(19) Europäisches Patentamt
European Patent Office
Office européen des brevets

(11) **EP 2 866 469 A2**

(12) **EUROPEAN PATENT APPLICATION**

(43) Date of publication:
**29.04.2015 Bulletin 2015/18**

(51) Int Cl.:
***H04R 19/00*** *(2006.01)*

(21) Application number: **14275037.1**

(22) Date of filing: **03.03.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **23.10.2013 KR 20130126788**

(71) Applicants:
• **Samsung Electro-Mechanics Co., Ltd.**
**Gyeonggi-do (KR)**
• **TOHOKU UNIVERSITY**
**Sendai-shi, Miyagi (JP)**

(72) Inventors:
• **Park, Yoon Sok**
**Gyeonggi-Do (KR)**
• **Esashi, Masayoshi**
**Sendai, 980-0845 (JP)**
• **Kang, Pil Joong**
**Gyeonggi-Do (KR)**

(74) Representative: **Potter Clarkson LLP**
**The Belgrave Centre**
**Talbot Street**
**Nottingham, NG1 5GG (GB)**

(54) **Acoustic transducer and package module including the same**

(57) There is provided an acoustic transducer (100) including an electrode substrate (120) having a plurality of holes (124) formed therein and having a first electrode thereon, a diaphragm (140) disposed so as to face the electrode substrate (120) and having a second electrode thereon to form an electric field in a space between the diaphragm (140) and the electrode substrate (120), and a plurality of protrusions (142) formed on the diaphragm (140) and having the second electrode to form electric fields in the plurality of holes (124).

FIG. 1

## Description

### CROSS-REFERENCE TO RELATED APPLICATION

This application claims the benefit of Korean Patent Application No. 10-2013-0126788 filed on October 23, 2013, with the Korean Intellectual Property Office, the disclosure of which is incorporated herein in its entirety by reference.

### BACKGROUND

The present technology generally relates to an acoustic transducer and a package module including the same. Unless otherwise indicated herein, the materials described in this section are not prior art to the claims herein and are not admitted to be prior art by inclusion in this section.

In accordance with the miniaturization of electronic products, components mounted therein have been miniaturized. Therefore, a microelectromechanical system (MEMS) acoustic transducer has come to prominence as an acoustic signal input apparatus widely used in mobile communications terminals, audio apparatuses, and the like.

MEMS acoustic transducers may be mainly classified as, for example, piezoresistive-type MEMS acoustic transducers, piezoelectric-type MEMS acoustic transducers, and condenser-type MEMS acoustic transducers.

Since piezoresistive-type MEMS acoustic transducers utilize a principle in which a resistance value is changed by vibrations, such a resistance value may be changed depending on changes in the surrounding environment (for example, changes in ambient temperature), such that a constant acoustic band frequency response may not be maintained.

In addition, since piezoelectric-type MEMS acoustic transducers use a piezoelectric effect generated in a diaphragm, a change in an electrical signal may occur, as the diaphragm is bent due to the pressure of an audio signal. However, as piezoelectricity is typically realized by deposition of piezoelectric material on top of a Silicon membrane, heterogeneous nature of diaphragm structure may obstruct the movement of the diaphragm, resulting in uneven acoustic band frequency response (for example, diaphragm movement may be different when the diaphragm is bent upward and downward, which may result in signal distortion).

Condenser-type MEMS acoustic transducers have a structure in which one of two metal flat plates is provided as a fixed electrode, the other of the two metal flat plates is used as a diaphragm vibrating in response to an acoustic signal, and an air gap of several to several tens of micrometers ($\mu$m) is positioned between the two electrodes. Since condenser-type MEMS acoustic transducers measure a change in capacitance between the diaphragm and the fixed electrode when the diaphragm vibrates, depending on an acoustic source, frequency characteristics and stability of a transduced acoustic band may be excellent.

Patent Documents 1 to 6 listed below relate to art associated with the condenser-type MEMS acoustic transducer.

[Related Art Document]

(Patent Document 1) U.S. Patent No. 6,535,460 B2
(Patent Document 2) U.S. Patent No. 7,449,356 B2
(Patent Document 3) U.S. Patent No. 7,885,423 B2
(Patent Document 4) U.S. Patent No. 7,912,236 B2
(Patent Document 5) U.S. Patent No. 7,961,897 B2
(Patent Document 6) U.S. Patent No. 8,103,027 B2

### SUMMARY

Some embodiments of the present disclosure may provide a condenser-type acoustic transducer capable of improving sensitivity to acoustic waves, and a package module including the same.

According to some embodiments of the present disclosure, an acoustic transducer may include an electrode substrate having a plurality of holes formed therein and having a first electrode thereon, a diaphragm disposed so as to face the electrode substrate and having a second electrode thereon to form an electric field in a space between the diaphragm and the electrode substrate, and a plurality of protrusions formed on the diaphragm and having the second electrode thereon to form electric fields in the plurality of the holes of the electrode substrate.

Some embodiments of the acoustic transducer may, for example, improve sensitivity to acoustic waves by the plurality of protrusions.

According to some embodiments of the present disclosure, an acoustic transducer may comprise an electrode substrate having at least one or more first holes formed therein and a first electrode thereon, a diaphragm having a second electrode thereon for forming an electric field in a space between the diaphragm and the electrode substrate, a support substrate having at least one or more second holes formed therein and a third electrode thereon to form the electric field in a space between the support substrate and the diaphragm, and first and second protrusions respectively formed on both surfaces of the diaphragm and having the second electrode thereon to form electric fields in inner walls of the first and second holes. The diaphragm may be disposed between the electrode substrate and the support substrate.

Some embodiments of the acoustic transducer may, for instance, improve sensitivity to acoustic waves by the protrusions formed on both surfaces of the diaphragm. For example, the protrusions formed on both surfaces of the diaphragm may be useful for decreasing noise.

According to some embodiments of the present disclosure, an acoustic transducer may include a support substrate having an acoustic wave input chamber formed thereon, the acoustic wave input chamber having acoustic waves input thereto, a first electrode substrate having at least one or more first holes formed therein and having a first electrode thereon, a second electrode substrate having at least one or more second holes formed therein and having a first electrode thereon, and a diaphragm disposed between the first and second electrode substrate and having first and second protrusions formed thereon so as to be inserted into the first and second holes. The diaphragm may have a second electrode thereon.

Some embodiments of the acoustic transducer may have a symmetrical structure to the diaphragm, and this structure may be easily manufactured.

According to some embodiments of the present disclosure, a package module may include an acoustic transducer mounted on a circuit board, and a semiconductor device mounted on the circuit board and connected to the acoustic transducer. The acoustic transducer may include a diaphragm having at least three first electrode surfaces, and an electrode substrate having second electrode surfaces corresponding to the first electrode surfaces.

## BRIEF DESCRIPTION OF DRAWINGS

Embodiments of the present disclosure will be more clearly understood from the following description taken in conjunction with the accompanying drawings, in which:

FIG. 1 is a cross-sectional view of an acoustic transducer according to an exemplary embodiment of the present disclosure;
FIG. 2 is a plan view of a diaphragm illustrated in FIG. 1;
FIG. 3 is an enlarged view of part A illustrated in FIG. 1;
FIGS. 4 and 5 are enlarged views of part A illustrating an acoustic wave sensing principle of the acoustic transducer illustrated in FIG. 1;
FIGS. 6 and 7 are views showing further exemplary embodiments of the acoustic transducer illustrated in FIG. 1;
FIGS. 8 through 11 are cross-sectional views showing further exemplary embodiments of the acoustic transducer illustrated in FIG. 1;
FIG. 12 is a cross-sectional view of an acoustic transducer according to another exemplary embodiment of the present disclosure;
FIG. 13 is an enlarged view of part B illustrated in FIG. 12;
FIGS. 14 and 15 are enlarged views of part B illustrating an acoustic wave sensing principle of the acoustic transducer illustrated in FIG. 12;
FIGS. 16 through 19 are views showing exemplary embodiments illustrating connection forms between a diaphragm and an elastic support member illustrated in FIG. 12;
FIGS. 20 through 23 are cross-sectional views showing further exemplary embodiments of the acoustic transducer illustrated in FIG. 12;
FIG. 24 is a cross-sectional view of an acoustic transducer according to another exemplary embodiment of the present disclosure; and
FIG. 25 is a cross-sectional view of a package module according to an exemplary embodiment of the present disclosure.

## DETAILED DESCRIPTION

Exemplary embodiments of the present disclosure will now be described in detail with reference to the accompanying drawings.

The disclosure may, however, be exemplified in many different forms and should not be construed as being limited to the specific embodiments set forth herein. Rather, these embodiments are provided to explain the principles of the invention and its practical applications, thereby enabling others skilled in the art to understand the invention for various embodiments and with various modifications as are suited to the particular use contemplated.

In the drawings, the shapes and dimensions of elements may be exaggerated for clarity, and the same reference numerals will be used throughout to designate the same or like elements. It will also be understood that, although the terms first, second, etc. may be used herein to describe various elements, these elements should not be limited by these terms. These terms are only used to distinguish one element from another. As used in this description and the appended claims, the singular forms "a", "an" and "the" are intended to include the plural forms as well, unless the context clearly indicates otherwise.

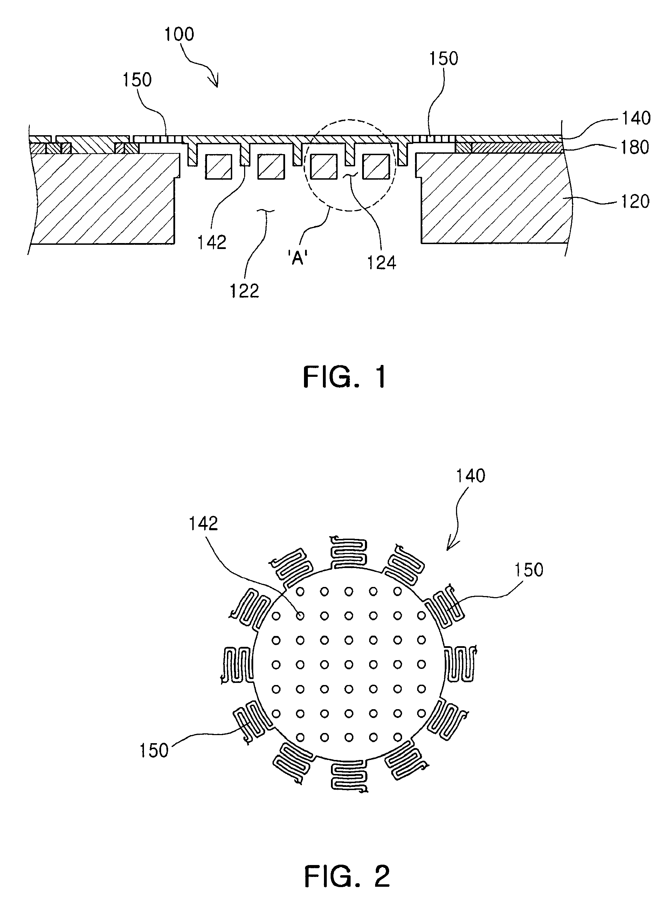

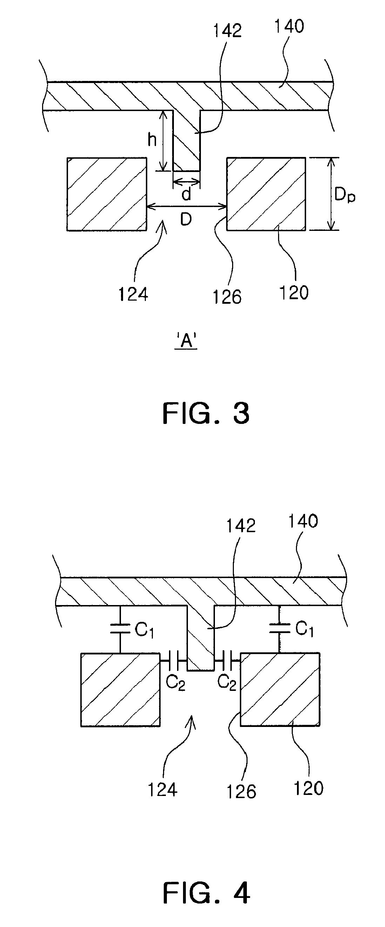

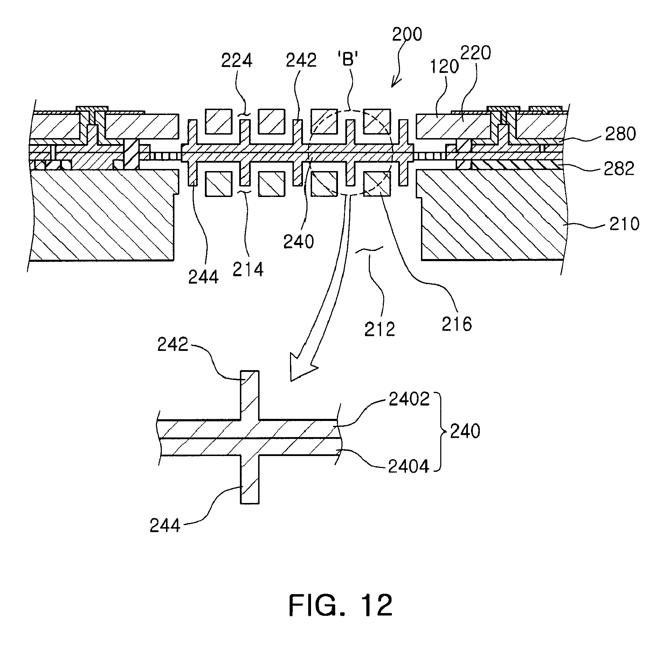

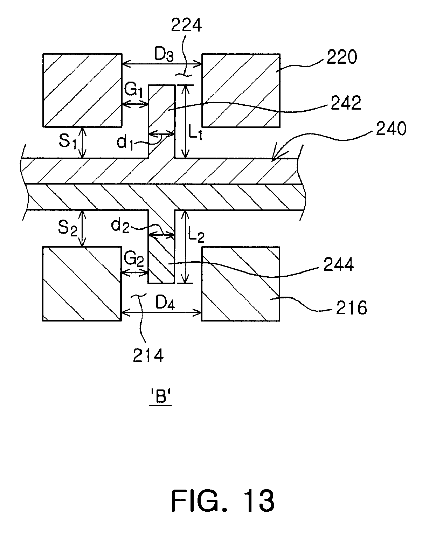

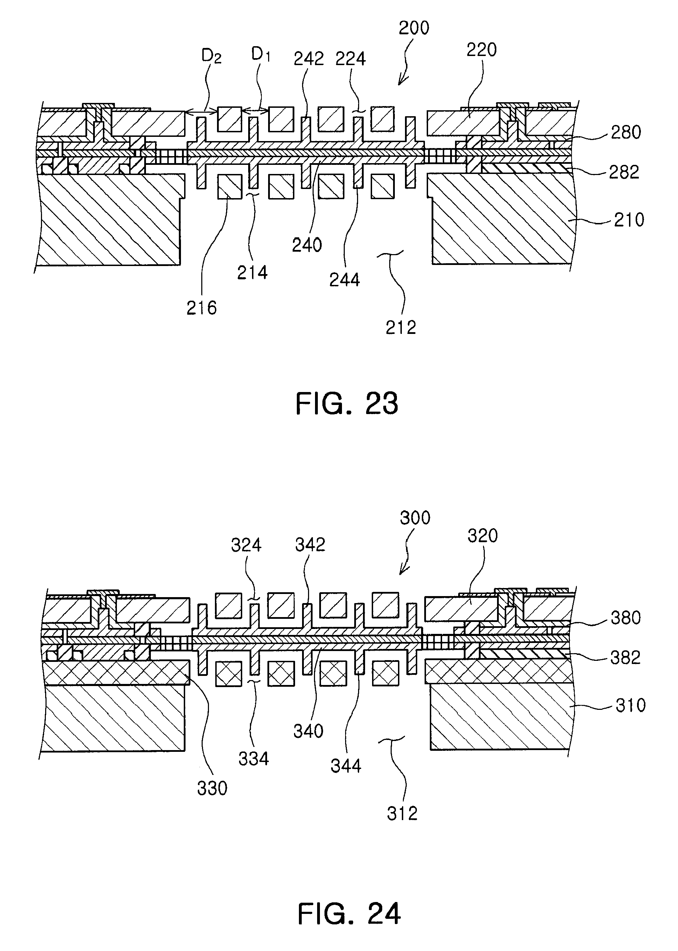

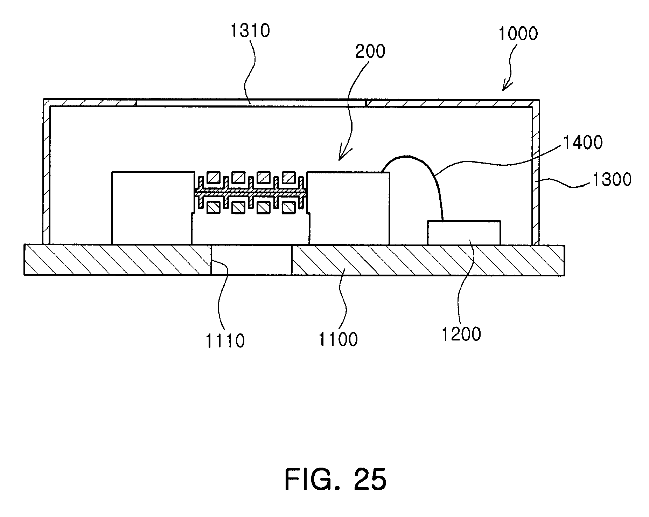

FIG. 1 is a cross-sectional view of an acoustic transducer according to an exemplary embodiment of the present disclosure; FIG. 2 is a plan view of a diaphragm illustrated in FIG. 1; FIG. 3 is an enlarged view of part A illustrated in FIG. 1; FIGS. 4 and 5 are enlarged views of part A illustrating an acoustic wave sensing principle of the acoustic transducer illustrated in FIG. 1; FIGS. 6 and 7 are views showing further exemplary embodiments of the acoustic transducer illustrated in FIG. 1; FIGS. 8 through 11 are cross-sectional views showing further exemplary embodiments of the acoustic transducer illustrated in FIG. 1; FIG. 12 is a cross-sectional view of an acoustic transducer according to another exemplary embodiment of the present disclosure; FIG. 13 is an enlarged view of part B illustrated in FIG. 12; FIGS. 14 and 15 are enlarged views of part B illustrating an acoustic wave sensing principle of the acoustic transducer illustrated in FIG. 12; FIGS. 16 through 19 are views showing exemplary embodiments illustrating connection between a diaphragm and an elastic support member illustrated in FIG. 12; FIGS. 20 through 23 are cross-sectional views showing further exemplary embodiments of the acoustic transducer illustrated in FIG. 12; FIG. 24 is a cross-sectional view of an acoustic transducer according to another exemplary embodiment of the present disclosure; and FIG. 25 is a cross-sectional view of a package module according to an exemplary embodiment of the present disclosure.

In some embodiments, a condenser-type acoustic transducer is excellent in terms of stability and frequency characteristics of a transduced acoustic band. However, since sensitivity to acoustic waves in the condenser-type acoustic transducer is in proportion to a magnitude of an electric field or a capacitance formed between a diaphragm and an electrode substrate, a size of the diaphragm may be increased in order to improve the sensitivity thereof to acoustic waves.

Embodiments of the present disclosure may provide a structure of an acoustic transducer having improved sensitivity to acoustic waves without increasing a size of a diaphragm or of the acoustic transducer.

An acoustic transducer according to an exemplary embodiment of the present disclosure is described with reference to FIGS. 1 through 5.

The acoustic transducer 100 according to the exemplary embodiment may include an electrode substrate 120 and a diaphragm 140. The acoustic transducer 100 may further include an insulating layer 180 for preventing electrical connections formed between the electrode substrate 120 and the diaphragm 140. The acoustic transducer 100 may further include a first electrical circuit generating an electric field formed between the electrode substrate 120 and the diaphragm 140. For example, the first electrical circuit may have a predetermined voltage and supply a direct current (DC) or alternating current (AC) voltage to the electrode substrate 120 and the diaphragm 140. The acoustic transducer 100 may further include a second electrical circuit sensing a change in the electric field or in the capacitance formed between the electrode substrate 120 and the diaphragm 140. For instance, the second electrical circuit may include an amplifying circuit amplifying change in the electric field or in the capacitance. In addition, the second electrical circuit may be formed integrally with the first electrical circuit. The acoustic transducer 100 may further include an elastic support member 150. The elastic support member 150 may be extended in a meandering form.

Next, some components of the acoustic transducer 100 are described in detail.

The electrode substrate 120 may form a body of the acoustic transducer 100. Alternatively, the electrode substrate 120 may be a portion of a portable terminal or a small electronic apparatus in which the acoustic transducer 100 is mounted. For example, the electrode substrate 120 may be a portion of a semiconductor package mounted in the portable terminal.

The electrode substrate 120 may include an acoustic wave input chamber 122 formed therein. For example, the acoustic wave input chamber 122 may be formed by mechanical processing or chemical processing. Additionally, the acoustic wave input chamber 122 may be formed by a dry or wet etching process. The acoustic wave input chamber 122 may temporarily store acoustic waves input from the outside of the acoustic transducer 100 and guide acoustic waves to the diaphragm 140. The acoustic wave input chamber 122 may form a back volume or a front volume required for sensing acoustic waves.

A cross section of the acoustic wave input chamber 122 may have a shape gradually narrowing from one surface (a lower surface, based on FIG. 1) of the electrode substrate 120 toward the other surface (an upper surface, based on FIG. 1) thereof. Since the shape of the cross section described above is effective to concentrate acoustic waves input from the outside on a single location, sensitivity to acoustic waves may be improved. However, the cross section of the acoustic wave input chamber 122 is not limited to having the above-mentioned shape. For example, the acoustic wave input chamber 122 may have a cylindrical shape in which sizes of cross sections thereof in a vertical direction (direction based on FIG. 1) are the same as each other, as illustrated in FIG. 1.

The electrode substrate 120 may be made of a material having relatively high conductivity. For example, the electrode substrate 120 may be made of doped silicon. However, the electrode substrate 120 is not limited to being made of the silicon, but may be formed of other materials as needed. Although the exemplary embodiment in which the electrode substrate 120 includes one substrate is illustrated in FIG. 1, the electrode substrate 120 may have a multilayered substrate in which a plurality of substrates is stacked.

The electrode substrate 120 may have at least one or more holes 124 formed therein. For example, the electrode substrate 120 may have a plurality of holes 124 formed therein so as to be connected to the acoustic wave input chamber 122. The holes 124 may penetrate through the electrode substrate 120 vertically. Therefore, the acoustic waves input from the acoustic wave input chamber 122 of the electrode substrate 120 may move to the diaphragm 140 through the holes 124. The hole 124 may have a predetermined size D and depth Dp (See FIG. 3). The hole 124 may have a circular cross sectional shape or a polygonal cross sectional shape.

The electrode substrate 120 may be formed of a conductive material. For example, the electrode substrate 120 may be formed of doped silicon. Therefore, a surface of the electrode substrate 120 (e.g., a lower surface of the electrode substrate 120 in FIG. 1) facing the diaphragm 140 and an inner wall 126 (See FIG. 3) of the hole 124 may be formed of a first electrode.

The diaphragm 140 may be disposed on one side of the electrode substrate 120. For example, the diaphragm 140 may be disposed over the electrode substrate 120 as illustrated in FIG. 1. The diaphragm 140 may vibrate in the vertical direction (based on FIG. 1) due to the acoustic waves input from the acoustic wave input chamber 122.

The diaphragm 140 may generally have a disk shape. For example, the diaphragm 140 may have a circular cross-sectional shape having substantially the same size as the cross section of the acoustic wave input chamber 122. However, the cross section of the diaphragm 140 is not limited to having the circular shape, but may have a polygonal shape such as a quadrangular shape, a pentagonal shape, or the like. In addition, the size of the cross section of the diaphragm 140 may not be the same as that of the cross section of the acoustic wave input chamber 122, but may be larger or smaller than the cross section of the acoustic wave input chamber 122, as needed.

The diaphragm 140 may be made of a conductive material. For example, the diaphragm 140 may be made of doped polysilicon. However, the diaphragm 140 is not limited to being made of the doped polysilicon. For example, the diaphragm 140 may be made of any material having electrical conductivity.

The diaphragm 140 may have the elastic support member 150 as illustrated in FIG. 2. The elastic support member 150 may be extended to one side of the electrode substrate 120, and may couple the diaphragm 140 and the first electrical circuit to each other. The diaphragm 140 connected to the first electrical circuit may have a second electrode thereon. Therefore, an electric field having a predetermined magnitude may be formed between the electrode substrate 120 and the diaphragm 140.

The elastic support member 150 may have a form in which a plurality of curved portions thereof is repeatedly connected to each other as illustrated in FIG. 2. For example, the elastic support member 150 may have a meandering form. However, the elastic support member 150 is not limited to having the above-mentioned shape, but may have various shapes which enable vertical movement of the diaphragm 140.

The elastic support member 150 may expand and contract in response to vertical vibrations of the diaphragm 140. For example, the elastic support member 150 may expand when the diaphragm 140 moves upwardly or downwardly and may contract when the diaphragm 140 returns to its original position.

The elastic support member 150 expanding and contracting as described above may allow the entire diaphragm 140 to vibrate vertically due to acoustic waves. Therefore, the diaphragm 140 may not be deformed such as warpage due to which a portion of the diaphragm 120 may have a convex or concave form.

The diaphragm 140 may have at least one protrusion 142 formed thereon. The protrusion 142 may be extended from one surface of the diaphragm 140 toward the electrode substrate 120. The protrusion 142 may have a pillar shape having a predetermined length h and a diameter d. For example, the diameter d may be smaller than a diameter D of the hole 124. In addition, the protrusions 142 may be disposed to correspond to the holes 124 of the electrode substrate 120 (See FIG. 3). The protrusions 142 disposed as described above may be inserted into or withdrawn from the holes 124 of the electrode substrate 120 in response to the vertical vibrations of the diaphragm 140. For example, the protrusions 142 may be inserted into the holes 124, respectively, when the diaphragm 140 is moved toward the electrode substrate 120. The protrusions 142 may be removed from the holes 124, respectively, when the diaphragm 140 moves apart from the electrode substrate 120.

The protrusion 142 may have an electrode formed thereon. The electrode formed on the protrusion 142 and the electrode formed on the diaphragm 140 may be a common electrode. For example, the protrusion 142 may have the second electrode formed thereon. To this end, the protrusion 142 may be formed of an electrode material, or a surface of the protrusion 142 may be coated with an electrode material. The protrusion 142 having the second electrode formed thereon as described above may change an electric field while being inserted into or withdrawn from the hole 124 in the first electrode.

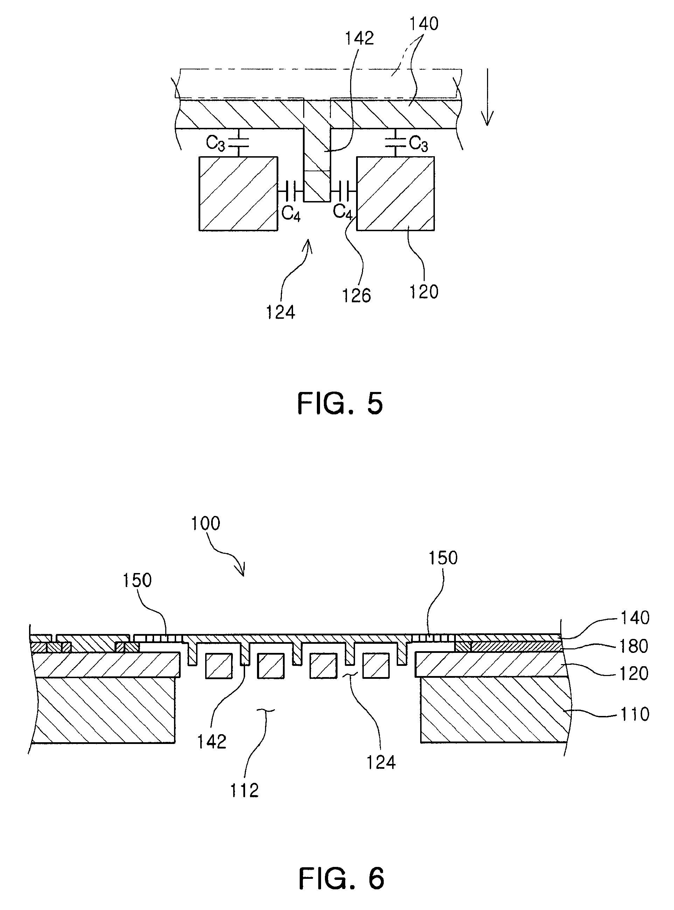

Next, an acoustic wave sensing principle of the acoustic transducer 100 according to an exemplary embodiment of the present disclosure is described with reference to FIGS. 4 and 5.

In a state in which acoustic waves are not input, a distance between the electrode substrate 120 and the diaphragm 140 is constantly maintained, such that an electric field having a first magnitude may be constantly formed between the electrode substrate 120 and the diaphragm 140. For example, a capacitance C1 may be formed between an upper surface of the electrode substrate 120 and a lower surface of the diaphragm 140, and a capacitance C2 may be formed between the inner wall 126 of the hole 124 and the protrusion 142.

When acoustic waves are input, the distance between the electrode substrate 120 and the diaphragm 140 is changed, such that an electric field having a second magnitude may be temporarily formed between the electrode substrate 120 and the diaphragm 140. For example, at a point in time at which the electrode substrate 120 and the diaphragm 140 become close to each other by vibrations of the diaphragm 140, a capacitance C3 may be formed between the upper surface of the electrode substrate 120 and the lower surface of the diaphragm 140 and a capacitance C4 may be formed between the hole 124 and the protrusion 142.

The capacitance C3 may have a magnitude different from that of the capacitance C1. In addition, the capacitance C4 may have a magnitude different from that of the capacitance C2. Therefore, acoustic waves may be sensed by a difference between the capacitances C3 and C1 and/or a difference between the capacitances C4 and C2. For instance, in the acoustic transducer 100 according to this exemplary embodiment, since the capacitance C4 is significantly larger than the capacitance C2 (e.g., the capacitance C2 may approximate a value close to 0 in the state in which the protrusion 142 is not inserted into the hole 124), sensitivity to acoustic waves may be improved by the difference between the capacitances C4 and C2.

Therefore, in the acoustic transducer 100 according to this exemplary embodiment, sensitivity to acoustic waves may be improved without increasing a size of the diaphragm 140 or the acoustic transducer 100.

Next, other exemplary forms of the acoustic transducer according to an exemplary embodiment of the present disclosure are described with reference to FIGS. 6 through 11.

One exemplary form of the acoustic transducer 100 is described with reference to FIG. 6.

Another form of the acoustic transducer 100 may further include a support substrate 110. For example, the acoustic transducer 100 may separately have the support substrate 110 in which an acoustic wave input chamber 112 is formed. Therefore, the electrode substrate 120 may be simplified to have a form in which it has a plurality of holes 124 formed therein.

In the acoustic transducer 100 configured as described above, since the acoustic wave input chamber 112 and the holes 124 are separately formed in the support substrate 110 and the electrode substrate 120, respectively, the acoustic wave input chamber 112 and the holes 124 may be easily formed in an etching process. For example, in this form, the electrode substrate 120 may be easily manufactured.

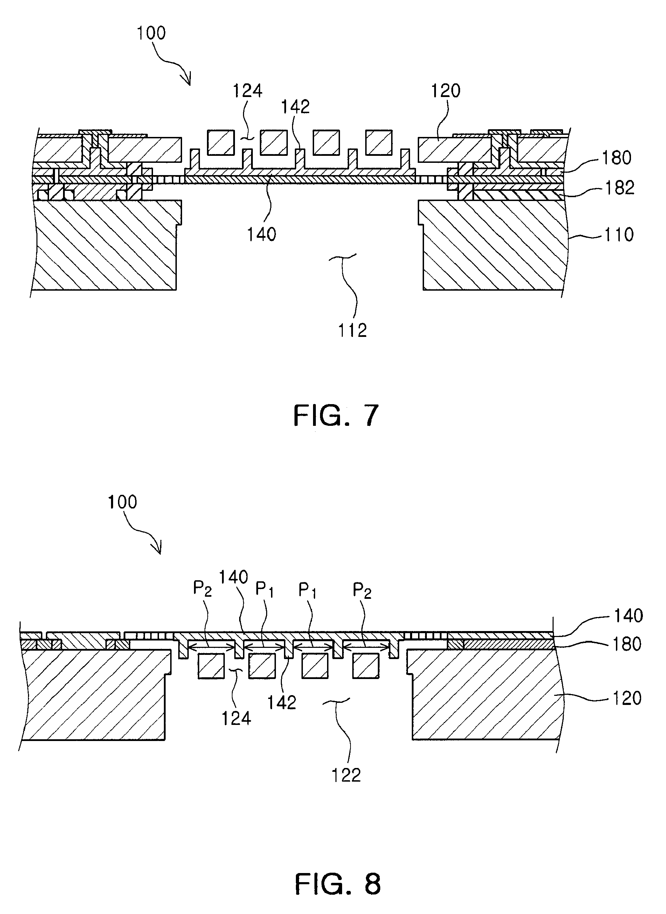

Another exemplary form of the acoustic transducer 100 is described with reference to FIG. 7.

As illustrated in FIG. 7, protrusions 142 may be formed in a direction different from the above-mentioned exemplary forms. For example, the protrusions 142 may be extended away from the acoustic wave input chamber 112. Therefore, the electrode substrate 120 may be disposed over the diaphragm 140. An input direction of acoustic waves in this exemplary form may be opposite to an input direction of the acoustic waves in FIG. 1.

Next, another exemplary form of the acoustic transducer 100 is described with reference to FIG. 8.

The acoustic transducer 100 may have different distances between holes 124 and/or different distances between protrusions 142. For example, the holes 124 and the protrusions 142 may be formed to be densified toward a central portion of the diaphragm 140 from an edge thereof, respectively. For example, a gap P1 between protrusions 142 disposed in the central portion of the diaphragm 140 may be smaller than a gap P2 between protrusions 142 disposed at the edge of the diaphragm 140.

In the acoustic transducer 100, the holes 124 and the protrusions 142 may be intensively disposed in the central portion of the diaphragm 140 having a relatively large amplitude. In this exemplary embodiment, changes in capacitance formed between the holes 124 and the protrusions 142 may be increased. As a result, sensitivity to acoustic waves may be improved. This exemplary form may be useful, for instance, in the case in which deformation of the diaphragm 140 by the acoustic waves is concentrated on the central portion of the diaphragm 140.

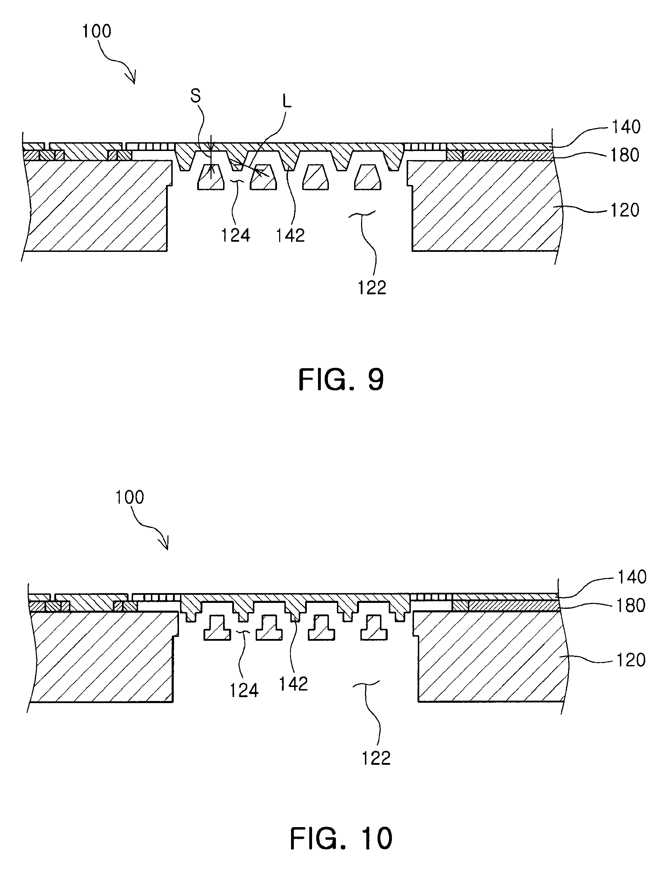

Next, another exemplary form of the acoustic transducer 100 is described with reference to FIGS. 9 and 10.

The acoustic transducer 100 may have various shapes of holes 124 and protrusions 142.

As an example, the protrusion 142 may have a truncated conical shape or a truncated pyramidal shape. The hole 124 may have a shape which may accommodate the entirety or a portion of the protrusion 142 (See FIG. 9). A distance S from an upper surface of the electrode substrate 120 to a lower surface of the diaphragm 140 may be substantially the same as a distance L from an oblique surface of the protrusion 142 to an inner wall of the hole 124 when the diaphragm 140 is in a stationary state. However, the distance S and the distance L are not necessarily the same as each other. For example, the distance S may be larger than the distance L, and the distance L may be larger than the distance S.

The protrusion 142 may have a stair shaped cross section. The hole 124 may have a shape corresponding to that of the protrusion 142 (See FIG. 10).

In the acoustic transducer 100 illustrated in FIGS. 9 and 10, since areas of the hole 124 and the protrusion 142 facing each other are relatively increased, a change in capacitance formed between the hole 124 and the protrusion 142 may be increased. Therefore, this exemplary form of the acoustic transducer 100 may be useful in the case for improving sensitivity to acoustic waves.

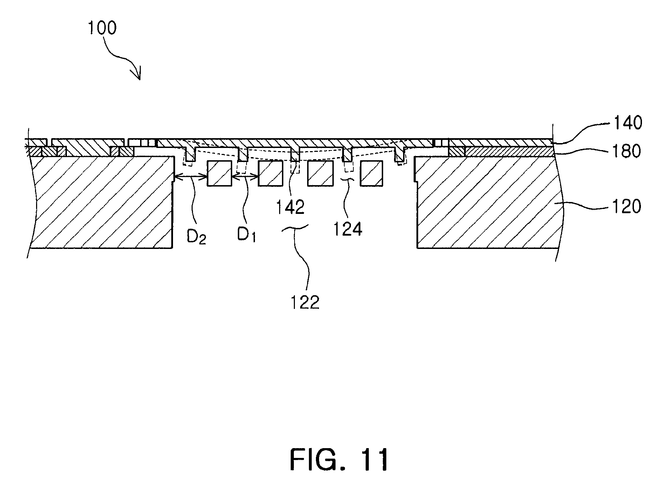

Next, another exemplary form of the acoustic transducer 100 is described with reference to FIG. 11.

The acoustic transducer 100 may have various shapes of the hole 124. For example, the size of the holes 124 may be increased toward an edge of the diaphragm 140 from a central portion of the diaphragm 140. For example, among the holes 124, a size D2 of a hole positioned at an edge of the electrode substrate 120 may be larger than a size D1 of a hole positioned in the central portion of the electrode substrate 120.

This exemplary form of the acoustic transducer 100 may be useful in the case in which a central portion of the diaphragm 140 is deformed by acoustic waves so as to be convex or concave.

For example, when the diaphragm 140 is deformed in a curved shape by acoustic waves (See dotted line of FIG. 11), the protrusion 142 formed near the edge of the diaphragm 140 may contact an inner wall of the hole 124 or the electrode substrate 120. In this case, an electric field formed between the electrode substrate 120 and the diaphragm 140 may be entirely removed or significantly decreased to deteriorate sensitivity to acoustic waves. However, in the acoustic transducer 100 illustrated in FIG. 11, since a size of the hole 124 positioned at the edge is relatively large, a problem due to a contact between the electrode substrate 120 and the protrusion 142 may be significantly decreased.

Embodiments of an acoustic transducer are described with reference to FIGS. 12 through 15.

The multifaceted electrode acoustic transducer 200 according to this exemplary embodiment may include a support substrate 210, an electrode substrate 220, and a diaphragm 240. The acoustic transducer 200 may further include insulating layers, for example, first and second insulating layers 280 and 282. The first insulating layer 280 may be formed between the electrode substrate 220 and the diaphragm 240. The second insulating layer 282 may be formed between the diaphragm 240 and the support substrate 210.

The acoustic transducer 200 may further include a first electrical circuit forming a first electrical field or a first capacitance between the electrode substrate 220 and the diaphragm 240. The first electrical circuit may have a predetermined voltage and supply a DC or AC current to the electrode substrate 220 and the diaphragm 240. The acoustic transducer 200 may further include a second electrical circuit forming a second electrical field or a second capacitance between the support substrate 210 and the diaphragm 240. The second electrical circuit may have a predetermined voltage and supply a DC or AC current to the support substrate 210 and the diaphragm 240. The first and second electrical circuits may be the same circuit. The first and second electric fields and/or the first and second capacitances may have the same magnitude, respectively.

The acoustic transducer 200 may further include a third electrical circuit for sensing a change in the first electrical field or the first capacitance formed between the electrode substrate 220 and the diaphragm 240. The third electrical circuit may include an amplifying circuit for amplifying a change in the first electric field or the first capacitance. The acoustic transducer 200 may further include a fourth electrical circuit for sensing a change in the second electrical field or the second capacitance formed between the support substrate 210 and the diaphragm 240. The fourth electrical circuit may include an amplifying circuit for amplifying a change in the second electric field or the second capacitance. The fourth electrical circuit may be the same circuit as the third electrical circuit. The fourth electrical circuit may be formed integrally with the first and second electrical circuits.

Some components of the acoustic transducer 200 are described in detail. In the following description, a description of the components described in the above exemplary embodiments is omitted and only features of components different from the components of the above-mentioned exemplary embodiment are described.

The support substrate 210 may be made of a silicon material and have a first electrode thereon. An electrode material configuring an electrode may be formed on a portion of the support substrate 210. For example, a metal material may be deposited on a portion of the support substrate 210.

The support substrate 210 may include an acoustic wave input chamber 212 formed therein. The acoustic wave input chamber 212 may guide acoustic waves input from the outside to the diaphragm 240. The support substrate 210 may have an electrode part 216 formed therein. The electrode part 216 may be formed on one side of the acoustic wave input chamber 212

(e.g., an upper side of the acoustic wave input chamber 212 in FIG. 12) and may substantially form the first electrode in the support substrate 210. The electrode part 216 may have at least one hole 214 formed therein. The hole 214 may penetrate through the electrode part 216 to allow the acoustic waves input from the acoustic wave input chamber 212 to pass toward the diaphragm 240.

The electrode substrate 220 may face the electrode part 216. For example, the electrode substrate 220 may be disposed so as to be spaced apart from the electrode part 216 at a predetermined distance. The distance may be changed depending on, for example, a thickness of the diaphragm 240.

The electrode substrate 220 may include at least one hole 224 formed therein. For example, the holes 224 corresponding to the holes 214 have the same number as the holes 214 of the electrode part 216. The holes 224 may be formed in a region of the electrode substrate 220 facing the electrode part 216. However, the number of holes 224 formed in the electrode substrate 220 may not be the same as the number of holes 214 formed in the electrode part 216, and may be more or less than the number of holes 214 formed in the electrode part 216.

The electrode substrate 220 may have a second electrode thereon. Electrode layers may be formed on a lower surface (based on FIG. 12) of the electrode substrate 220 and an inner wall of the hole 224. Alternatively, the electrode substrate 220 may be made of an electrode material. For example, the electrode substrate 220 may be an electrode layer formed by depositing a metal material. The electrode substrate 220 formed as described above and the electrode part 216 may be connected to the first electrical circuit to thereby have electrodes formed thereon, respectively.

The diaphragm 240 may be formed between the support substrate 210 and the electrode substrate 220. For example, the diaphragm 240 may be disposed between the support substrate 210 and the electrode substrate 220 so as to vibrate in a vertical direction in FIG. 12.

The diaphragm 240 may have at least one or more electrodes formed thereon. For example, the diaphragm 240 may have a third electrode formed on one surface thereof (e.g. a lower surface of the diaphragm 240 in FIG. 12) and have a fourth electrode formed on the other surface thereof (e.g. an upper surface of the diaphragm 240 in FIG. 12). The diaphragm 240 may form, together with the electrode part 216 of the support substrate 210, a first electric field and may form, together with the electrode substrate 220, a second electric field. For reference, the third and fourth electrodes may be a common electrode formed by a single electrical circuit.

The diaphragm 240 may have a plurality of layers. For example, the diaphragm 240 may include a first electrode layer 2402 and a second electrode layer 2404. The first electrode layer 2402 may form the upper surface of the diaphragm 240, and the second electrode layer 2404 may form the lower surface of the diaphragm 240. For reference, although the exemplary embodiment in which the diaphragm 240 includes two electrode layers 2402 and 2404 is illustrated in FIG. 12, the diaphragm 240 may have only one electrode layer, as needed. The two electrode layers 2402 and 2404 may be bonded to each other by, for example, silicon direct bonding (SDB) to thereby be electrically connected to each other. An adhesive layer may be formed between the two electrode layers 2402 and 2404. The adhesive layer may not be needed depending on a method of adhering the first and second electrode layers 2402 and 2404 to each other.

The diaphragm 240 may have a plurality of protrusions 242 and 244 formed thereon. For example, first protrusions 242 may be formed on the upper surface of the diaphragm 240, and second protrusions 244 may be formed on the lower surface of the diaphragm 240. Here, the first protrusions 242 may be disposed so as to face the holes 224 of the electrode substrate 220, and the second protrusions 244 may be disposed so as to face the holes 214 of the electrode part 216. Alternatively, the first protrusions 242 may be disposed so as to be inserted into the holes 224 of the electrode substrate 220, and the second protrusions 244 may be disposed so as to be inserted into the holes 214 of the electrode part 216 when the diaphragm 240 is in a stationary state.

The protrusions 242 and 244 formed may move so as to be selectively inserted into the holes 224 and 214 corresponding thereto or may move so that a depth at which they are inserted into the holes 224 and 214 is changed, depending on vibrations of the diaphragm 240 due to acoustic waves.

Examples of layout structures in which the diaphragm 240 and the protrusions 242 and 244 and the holes 224 and 214 are formed are described in detail with reference to FIG. 13.

The diaphragm 240 may be disposed between the electrode part 216 of the support substrate 210 and the electrode substrate 220. A first distance S1 from the diaphragm 240 to the electrode substrate 220 may be the same as a second distance S2 from the diaphragm 240 to the electrode part 216. However, the first and second distances S1 and S2 are not necessarily the same as each other. For example, the first and second distances S1 and S2 may be different depending on shapes of the protrusions 242 and 244 and the holes 224 and 214 and/or the numbers of protrusions 242 and 244 and holes 224 and 214.

The first and second protrusions 242 and 244 may be formed to be symmetrical to the diaphragm 240. For example, the first protrusion 242 may be extended upwardly from the diaphragm 240, the second protrusion 244 may be extended downwardly from the diaphragm 240, and the first and second protrusions 242 and 244 may have the same height. For example, a height h1 of the first protrusion 242 may be the same as a height h2 of the second protrusion 244.

The holes 224 and 214 may face the protrusions 242 and 244 of the diaphragm 240, respectively. The holes 224 and 214 may have a size and a depth which can completely accommodate the protrusions 242 and 244, respectively. For example, a diameter D3 of the hole 224 may be larger than a diameter d1 of the first protrusion 242, and a diameter D4 of the hole 214 may be larger than a diameter d2 of the second protrusion 244. Therefore, a gap G1 having a first size may be formed between an inner wall of the hole 224 and a outer surface of the first protrusion 242, and a gap G2 having a second size may be formed between an inner wall of the hole 214 and a circumferential surface of the second protrusion 244. The gap G1 may be the same as the first distance S1, and the gap G2 may be the same as the second distance S2. The gap G1 may be the same as the gap G2.

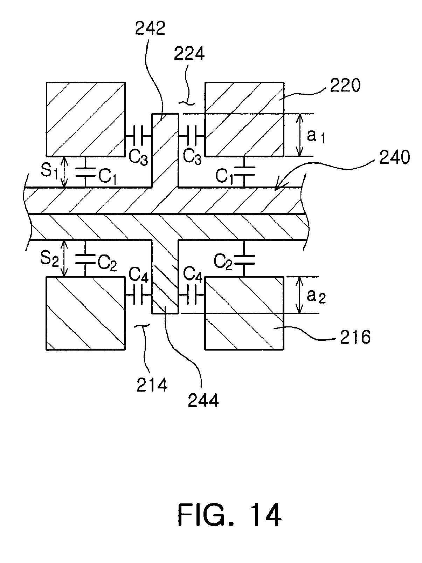

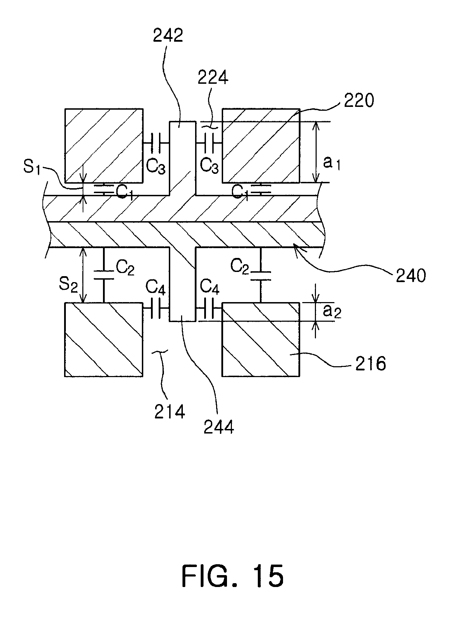

Next, an acoustic wave sensing principle of the acoustic transducer 200 according to the exemplary embodiment is described with reference to FIGS. 14 and 15.

When acoustic waves are not input, the diaphragm 240 of the acoustic transducer 200 may be maintained in a stopped state at an intermediate position between the electrode part 216 and the electrode substrate 220, as illustrated in FIG. 14. When an electrical circuit applies a voltage to each of the electrode part 216, the electrode substrate 220, and the diaphragm 240, a first capacitance C1 may be formed between the electrode substrate 220 and the diaphragm 240, and a second capacitance C2 may be formed between the electrode part 216 and the diaphragm 240. In addition, a third capacitance C3, in proportion to a length a1 of an area of the first protrusion 242 and an inner wall of the hole 224 facing each other, may be formed between the first protrusion 242 and an inner wall of the hole 224, and a fourth capacitance C4, in proportion to a length a2 of an area of the second protrusion 244 and an inner wall of the hole 214 facing each other, may be formed between the second protrusion 244 and an inner wall of the hole 214.

Then, when acoustic waves are input, the diaphragm 240 may vertically vibrate and capacitances may be changed as illustrated in FIG. 15. For example, when the diaphragm 240 moves upwardly, the first and third capacitances C1 and C3 may be increased and the second and fourth capacitances C2 and C4 may be decreased. To the contrary, when the diaphragm 240 moves downwardly, the first and third capacitances C1 and C3 may be decreased and the second and fourth capacitances C2 and C4 may be increased.

Therefore, when the diaphragm 240 repeatedly vibrates in vertical directions by acoustic waves for a predetermined time, the first to fourth capacitances C1 to C4 may be continuously changed. The change in the capacitance may be transferred to the electrical circuit in electrical signal form, and the electrical circuit may sense acoustic waves through the transferred electrical signal.

Amounts of changes in capacitances C1 to C4 in response to the vertical vibrations of the diaphragm 240 may be represented by the following Equation 1.

[Equation 1]

$$\text{Amount of Change in Capacitance} = \sum(C1 + \Delta C1 + C3 + \Delta C3 + \text{First Noise}) - \sum(C2 + \Delta C2 + C4 + \Delta C4 + \text{Second Noise})$$

For reference, in Equation 1, a first noise may indicate a noise component generated between the diaphragm 240 and the electrode substrate 220, and a second noise may indicate a noise component generated between the diaphragm 240 and the electrode part 216.

In the exemplary embodiment in which the diaphragm 240 is positioned at an intermediate point between the electrode substrate 220 and the electrode part 216 and the upper and lower surfaces of the diaphragm 240 are symmetrical to each other, the first and second capacitances C1 and C2 may be the same as each other and the third and fourth capacitances C3 and C4 may be the same as each other. Since the first and second noises may be substantially the same as each other, Equation 1 may be represented by a form of the following Equation 2.

[Equation 2]

$$\text{Amount of Change in Capacitance} = \sum(\Delta C1 + \Delta C3) - \sum(\Delta C2 + \Delta C4)$$

Since $\Delta C1$ and $\Delta C2$ have opposite signs and $\Delta C3$ and $\Delta C4$ have opposite signs (for example, in the case in which the first and third capacitances C1 and C3 are increased, the second and fourth capacitances C2 and C4 are decreased) in Equation 2, Equation 2 may be represented by a form of the following Equation 3.

[Equation 3]

$$\text{Amount of Change in Capacitance} = 2 \times \sum(\Delta C1 + \Delta C3)$$

As may be seen from Equation 3, the acoustic transducer 200 according to the exemplary embodiment may output an electrical signal (for example, a change in a capacitance) having a double magnitude with respect to the same acoustic wave and remove a significantly large noise component. Therefore, the acoustic transducer 200 according to this exemplary embodiment may more clearly and distinctly sense acoustic waves, as compared with the related art.

In addition, since the acoustic transducer 200 according to the exemplary embodiment may offset unnecessary noise by a multilayer electrode structure, a signal to noise ratio (SNR) may be improved.

Since the acoustic transducer 200 according to the exemplary embodiment has a differential capacitive sensing structure, an AC voltage may be used.

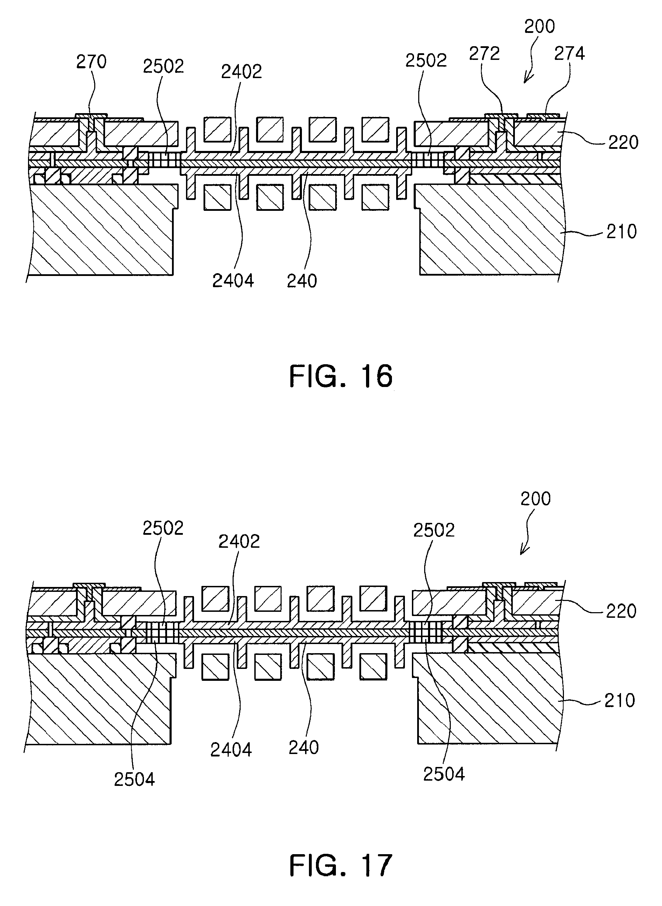

Next, exemplary embodiments of a connection structure between the diaphragm 240 and elastic support members 2502 and 2504 are described with reference to FIGS. 16 to 19.

The diaphragm 240 may be connected to a plurality of elastic support members 2502.

As an example, the first electrode layer 2402 of the diaphragm 240 may be connected to the plurality of elastic support members 2502 (See FIG. 16). The first electrode layer 2402 may be connected to a plurality of electrode terminals 272 by the elastic support members 2502. Electrode terminals 270 and 274 that are not connected to the first electrode layer 2402 may be connected to the support substrate 210 and/or the electrode substrate 220.

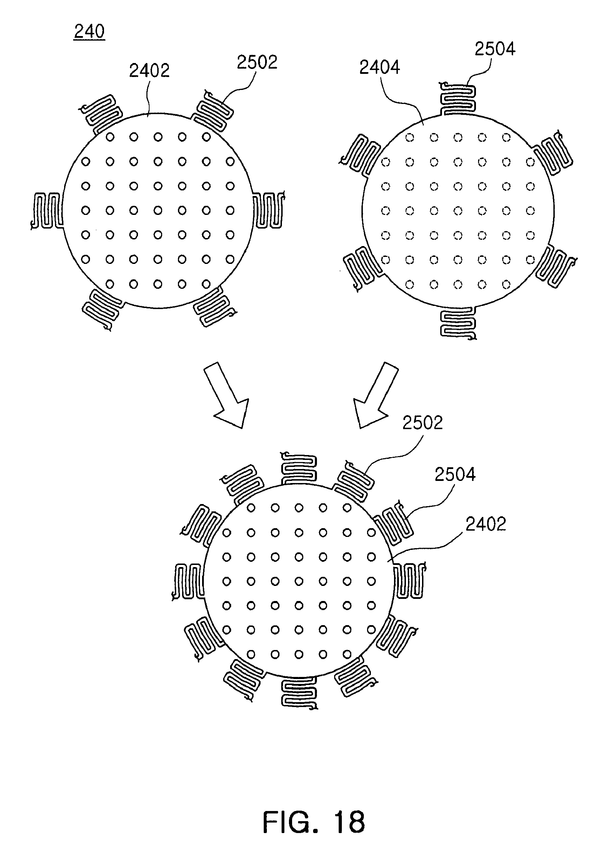

As another example, the first and second electrode layers 2402 and 2404 of the diaphragm 240 may be connected to a plurality of elastic support members 2502 and 2504, respectively (See FIGS. 17 and 18). For example, the first and second electrode layers 2402 and 2404 may have a plurality of elastic support members 2502 and 2504, respectively, as illustrated in FIG. 18. The elastic support members 2502 of the first electrode layer 2402 may be arranged not to be overlapped with the elastic support members 2504 of the second electrode layer 2404. However, the elastic support members 2502 of the first electrode layer 2402 and the elastic support members 2504 of the second electrode layer 2404 may be disposed so as to be overlapped with each other.

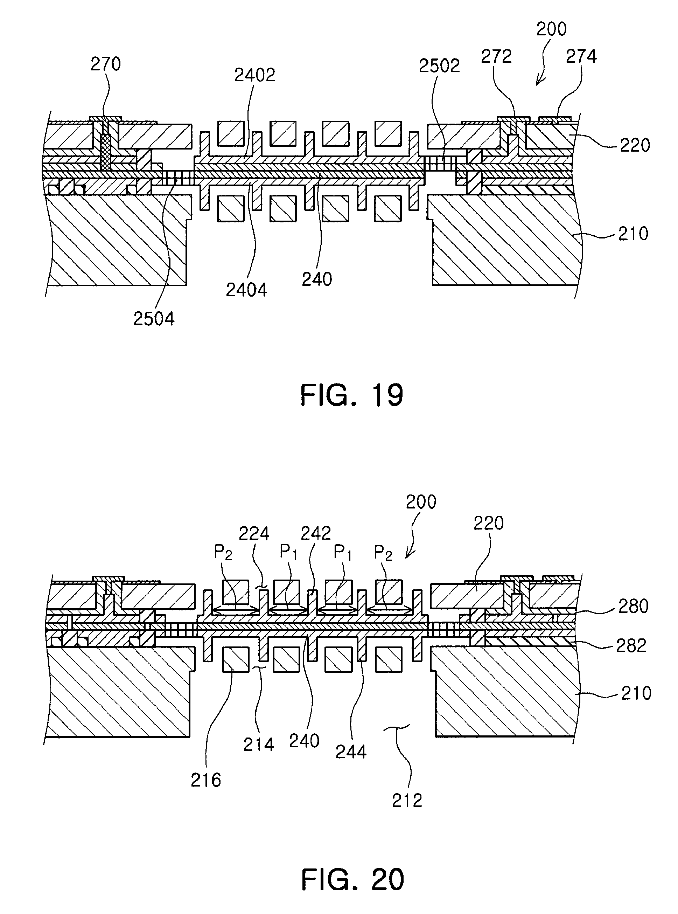

As another example, the first electrode layer 2402 of the diaphragm 240 may be connected to elastic support members 2502 extended in one direction, and the second electrode layer 2404 of the diaphragm 240 may be connected to elastic support members 2504 extended in the other direction (See FIG. 19).

Next, other exemplary forms of the acoustic transducer according to another exemplary embodiment of the present disclosure are described with reference to FIGS. 20 through 23.

First, one exemplary form of the acoustic transducer 200 is described with reference to FIG. 20.

Gaps between holes 224 and between holes 214 and gaps between protrusions 242 and protrusions 244 may be different. For example, the holes 224 and 214 and the protrusions 242 and 244 may be formed to have a density becoming denser from an edge of the diaphragm 240 toward a central portion thereof, respectively. For example, a gap P1 between protrusions 242 disposed in the central portion of the diaphragm 240 may be smaller than a gap P2 between protrusions 242 disposed at the edge of the diaphragm 240.

In the acoustic transducer 200 formed, since the holes 224 and 214 and the protrusions 242 and 244 are intensively disposed in a central portion of the diaphragm 240 having a relatively large amplitude, amounts of changes in capacitance formed between the holes 224 and 214 and the protrusions 242 and 244 may be increased. As a result, sensitivity to acoustic waves may be improved.

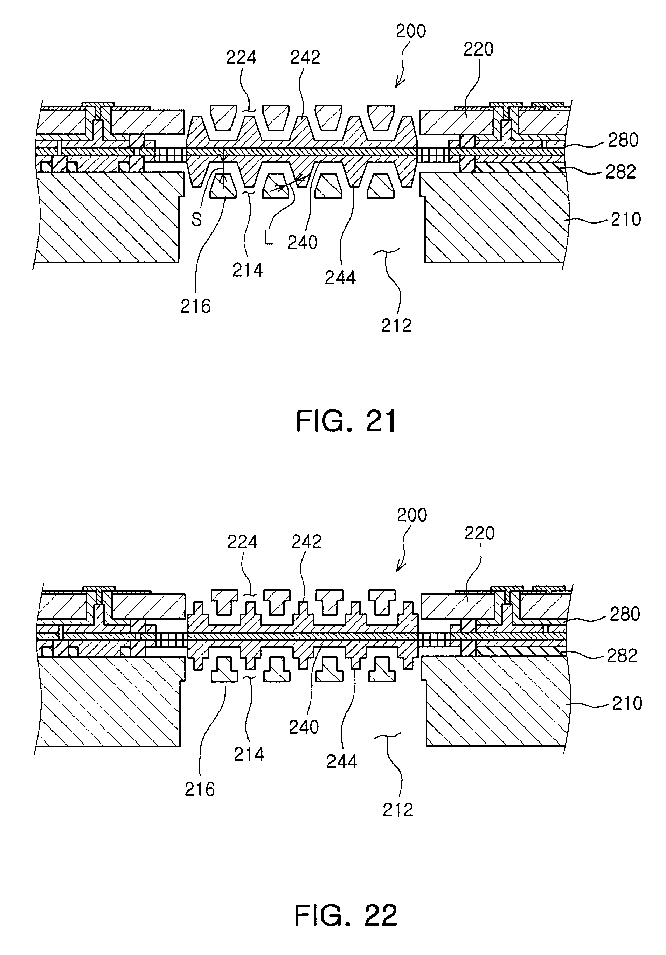

Next, another exemplary form of the acoustic transducer 200 is described with reference to FIGS. 21 and 22.

Holes 224 and 214 and protrusions 242 and 244 may have various shapes.

As an example, the protrusions 242 and 244 may have truncated conical shape or a truncated pyramidal shape, and the holes 224 and 214 may have a shape accommodating the entirety or a portion of the protrusions 242 and 244, respectively (See FIG. 21). A distance S from the electrode substrate 220 to the diaphragm 240 may be substantially the same as a distance L from oblique surfaces of the protrusions 242 and 214 to inner walls of the holes 224 and 214 when the diaphragm 240 is in a stationary state.

As another example, the protrusions 242 and 244 may have a multi-stage shape in which a plurality of members having cross sections with different sizes are stacked, and the holes 224 and 214 may have a shape corresponding to that of the protrusions 242 and 244 (See FIG. 22).

In the acoustic transducer 200, since areas of inner surfaces of the holes 224 and 214 and the protrusions 242 and 244 facing each other are relatively increased, amounts of changes in capacitances formed between the holes 224 and 214 and the protrusions 242 and 244 may be effectively increased. As a result, sensitivity to acoustic waves may be improved.

Next, another exemplary form of the acoustic transducer 200 is described with reference to FIG. 23.

The acoustic transducer 200 may have various shapes of holes 214 and 224. For example, the holes 214 and 224 may become larger from a central portion of the diaphragm 240 toward an edge thereof. For example, a size D2 of the holes 224 and 214 positioned at edges of the electrode substrate 220 and the electrode part 216, respectively, may be larger than a size D1 of the holes 224 and 214 positioned in central portions of the electrode substrate 220 and the electrode part 216, respectively.

This exemplary form of the acoustic transducer 200 may be useful in the case in which the diaphragm 240 is differently displaced by acoustic waves in each position. For example, this exemplary form of the acoustic transducer 200 may be useful in the case in which only a central portion of the diaphragm 240 is deformed so as to be convex or concave by acoustic waves.

An acoustic transducer according to another exemplary embodiment of the present disclosure is described with reference to FIG. 24. For reference, a description of the components described in the above exemplary embodiments is omitted.

The acoustic transducer 300 according to this exemplary embodiment may include a support substrate 310, a first electrode substrate 320, and a diaphragm 340. The acoustic transducer 300 may further include first and second insulating layers 380 and 382. The acoustic transducer 300 may further include a second electrode substrate 330 having holes 334 formed therein. The holes 334 may have second protrusions 344 of the diaphragm 340 inserted thereinto, respectively.

For example, in the acoustic transducer 300 according to this exemplary embodiment, the first and second electrode substrates 320 and 330 may be disposed symmetrically to the diaphragm 340. The first and second electrode substrates 320 and 330 may have the holes 324 and 334 formed therein. The holes 324 and 334 may have the protrusions 342 and 344 of the diaphragm 340 inserted thereinto, respectively.

Since the acoustic transducer 300 has a vertically symmetrical structure based on the diaphragm 340 (except for the support substrate 310), it may be easily manufactured.

Next, a package module according to an exemplary embodiment of the present disclosure is described with reference to FIG. 25. For reference, since an acoustic transducer to be described below has a configuration the same as or similar to those of the acoustic transducers represented by reference numerals 100, 200, and 300 as described above, a detailed description thereof is omitted.

The package module 1000 according to this exemplary embodiment may include the acoustic transducer 200, a circuit board 1100, an application specific integrated circuit (ASIC) 1200, and a shield can 1300. The package module 1000 may further include a separate active device and passive device.

The package module 1000 may be mounted in an apparatus in which an acoustic signal is required to be sensed. For example, the package module 1000 may be mounted in a portable audio apparatus, a portable cassette recorder, a portable communications apparatus, and the like, but not limited to the above-mentioned apparatuses. The package module 1000 may also be mounted in an apparatus sensing movements of air or a material having waveform energy that is the same as or similar to that of the acoustic waves.

The acoustic transducer 200 may have multifaceted electrodes. For example, the acoustic transducer 200 may include a diaphragm having different first electrode surfaces. In addition, the acoustic transducer 200 may include an electrode substrate having a second electrode surface corresponding to the first electrode surface.

For example, the diaphragm 240 may have a plane on which a first electrode is formed. The diaphragm 240 may include a plurality of protrusions 242 having the first electrode formed on outer surfaces thereof, respectively, aside from the plane

(See FIG. 12). The electrode substrate 220 may have a plane on which a second electrode is formed. The plane of the electrode substrate 220 may face the plane of the diaphragm 240 in the state in which it is spaced from the plane of the diaphragm 240 by a predetermined distance. The electrode substrate 220 may have holes 224 formed therein. The hole 224 may have a second electrode formed on an inner peripheral surface thereof. The second electrode may correspond to the first electrode formed on the circumferential surface of the protrusion 242.

The acoustic transducer 200 configured as described above may, for example, improve sensitivity to acoustic waves by a multifaceted electrode structure.

The circuit board 1100 may have circuit patterns. For example, the circuit board 1100 may include the circuit patterns formed on at least one surface thereof. The circuit board 1100 may have a hole 1110 formed therein. The hole 1110 may be used as an inlet through which acoustic waves are input.

The ASIC 1200 may be connected to the acoustic transducer 200. For example, the ASIC 1200 may convert a vibration signal of the acoustic transducer 200 into an electrical signal. The ASIC 1200 may amplify an acoustic signal of the acoustic transducer 200 using a preset logic circuit. The ASIC 1200 may remove a noise signal from the acoustic transducer 200 by using the preset logic circuit.

The exemplary embodiment in which the ASIC 1200 is disposed outside of the acoustic transducer 200 is illustrated in FIG. 25. However, the ASIC 1200 may be disposed inside the acoustic transducer 200, as needed. This configuration may be used for miniaturizing the package module 1000.

The shield can 1300 may protect the acoustic transducer 200 and the ASIC 1200. For example, the shield can 1300 may form a space in which the acoustic transducer 200 and the ASIC 1200 are accommodated. The shielding can 1300 may prevent from harmful electromagnetic waves. The shield can 1300 may form a front volume or a back volume required for sensing acoustic waves in the acoustic transducer 200. The shield can 1300 may have a hole 1310 formed therein in order to input or output acoustic waves. The package module may not have the hole 1310 therein.

Since the package module 1000 configured as described above includes the acoustic transducer 200 having the multifaceted electrode structure, it may improve sensitivity to acoustic waves.

As set forth above, according to some exemplary embodiments of the present disclosure, sensitivity to acoustic waves may be improved.

While exemplary embodiments have been illustrated and described above, it will be apparent to those skilled in the art that modifications and variations could be made without departing from the spirit and scope of the present disclosure as defined by the appended claims. Accordingly, the illustrative discussions above are not intended to be exhaustive or to limit the invention to the precise forms disclosed.

**Claims**

1. An acoustic transducer, comprising:

    a support substrate having an acoustic wave input chamber formed therein, the acoustic wave input chamber having acoustic waves input thereto;
    a first electrode substrate having one or more first holes and a first electrode;
    a second electrode substrate having one or more second holes and a second electrode; and
    a diaphragm disposed between the first and second electrode substrates, and having protrusions formed thereon so as to be inserted into the first and second holes, the diaphragm having a third electrode.

2. The acoustic transducer of claim 1, wherein the protrusions are inserted into the first and second holes.

3. The acoustic transducer of claim 1, wherein the first and second electrode substrates comprise doped silicon.

4. The acoustic transducer of claim 1, wherein the diaphragm comprises doped polysilicon.

5. The acoustic transducer of claim 1, wherein the protrusions are formed more in a center portion of the diaphragm than a periphery portion of the diaphragm.

6. The acoustic transducer of claim 1, wherein the protrusions have a truncated conical shape, a truncated pyramidal shape, a multi-stage shape, or a shape having cross-sectional areas changed in a protruding direction, and the first and second holes have shapes corresponding to those of the protrusions, respectively.

7. The acoustic transducer of claim 1, wherein sizes of the first and second holes become larger from a central portion of the diaphragm toward an edge of the diaphragm.

8. The acoustic transducer of claim 1, wherein the diaphragm includes one or more elastic support members extended in a meandering form.

9. The acoustic transducer of claim 1, wherein the numbers of the first protrusions are the same as the numbers of the second protrusions, and a magnitude of an electric field formed between the first electrode substrate and the diaphragm and a magnitude of an electric field formed between the second electrode substrate and the diaphragm are the same as each other when the diaphragm is in a stationary state.

10. A package module comprising:

    an acoustic transducer mounted on a circuit board; and
    a semiconductor device mounted on the circuit board and connected to the acoustic transducer,
    wherein the acoustic transducer comprises:

        a diaphragm having at least three first electrode surfaces; and
        an electrode substrate having second electrode surfaces corresponding to the first electrode surfaces.

11. The package module of claim 10, wherein the first electrode surfaces comprise:

    a first plane of the diaphragm; and
    surfaces with a plurality of protrusions extended from the first plane toward the electrode substrate.

**12.** The package module of claim 11, wherein the second electrode surfaces comprise:

a plane of the electrode substrate facing the first plane; and
inner surfaces of a plurality of holes into which the plurality of the protrusions are to be inserted.

**13.** The package module of claim 12, wherein the electrode substrate is disposed between the diaphragm and the circuit board.

**14.** The package module of claim 12, wherein the diaphragm is disposed between the electrode substrate and the circuit board.

**15.** The package module of claim 10, wherein the first electrode surfaces comprise:

a first plane of the diaphragm;
a second plane of the diaphragm; and
surfaces with a plurality of protrusions extended from the first and second planes in different directions.

**16.** The package module of claim 15, wherein the second electrode surfaces comprise:

a plurality of planes of the electrode substrate facing the first and second planes, respectively; and
inner surfaces of the plurality of holes formed in the planes, respectively, so that the plurality of protrusions are inserted thereinto, respectively.

FIG. 1

FIG. 2

EP 2 866 469 A2

FIG. 3

FIG. 4

15

**FIG. 5**

**FIG. 6**

FIG. 7

FIG. 8

EP 2 866 469 A2

FIG. 9

FIG. 10

18

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

1310    200    1000

1400

1300

1110    1100    1200

FIG. 25

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020130126788
- US 6535460 B2
- US 7449356 B2
- US 7885423 B2
- US 7912236 B2
- US 7961897 B2
- US 8103027 B2